# EUROPEAN PATENT APPLICATION

(11) **EP 3 457 150 A1**
(43) Date of publication of application: **20.03.2019**
(21) Application number: 18191650.3
(22) Date of filing: 30.08.2018
(51) Int. Cl.: G01R 31/34, G01R 31/12

(54) **SPARK DETECTING APPARATUS AND METHOD FOR DEVICES USING ELECTRIC SLIDING CONTACT, SPARK REDUCTION METHOD FOR DEVICES USING ELECTRIC SLIDING CONTACT, AND SLIDING ERROR DETECTING APPARATUS AND METHOD FOR DEVICES USING ELECTRIC SLIDING CONTACT**

(30) Priority: 13.09.2017 JP 2017175578
(71) Applicant: Mitsubishi Hitachi Power Systems, Ltd., Yokohama-shi, Kanagawa 220-8401 (JP)
(72) Inventor: YANAGITA, Norihito, Tokyo, 100-8332 (JP)
(74) Representative: Strehl Schübel-Hopf & Partner

(57) **Abstract**

There are provided a spark detecting apparatus for devices using electric sliding contact and a spark detecting method for devices using electric sliding contact, in which in an electric machine having an electric sliding contact mechanism, a spark occurring in an electric sliding contact section is detected early and accurately, so as to enable the unexpected stop avoidance and the static operation of the electric machine. A spark detecting apparatus for devices using electric sliding contact includes a static part, a sliding part becoming electrically conductive while making sliding contact with the static part, a frequency filter selectively passing a voltage signal in a particular band, a volt meter electrically connected to the static part through the frequency filter, and a detecting apparatus for sliding condition determining the presence or absence of spark at the sliding interface between the static part and the sliding part. When a voltage signal detected by the volt meter exceeds a predetermined threshold value, it is determined that a spark has occurred.

## Description

### BACKGROUND

The present invention relates to the configuration of an electric machine using an electric sliding contact mechanism, and in particular, to a technique that is effective in being applied to the spark detection of an electric sliding contact section.

A so-called electric sliding contact mechanism in which two different electric components come into contact with each other to slide while becoming electrically conductive between the electric components has been widely used for various products in many fields, as represented by a trolley wire and a pantograph for electric railroad, the brush and the slip ring (collector ring) of a rotating machine, and the like. In such an electric sliding contact mechanism, the electric components gradually wear due to sliding, thus requiring the maintenance operation including inspection and replacement.

However, the worn state of the electric components changes according to the operation conditions of the electric machine and the environment conditions around the electric machine, and the electric current flowing in each of the components is different to vary the wearing speed of each of the components, so that the omission of inspection stops the function of the electric sliding contact mechanism, which can cause a severe accident, such as the unexpected stop of the electric machine. Accordingly, a sliding condition monitoring and error detection technique for the electric components having the electric sliding contact mechanism has been proposed.

As the conventional technique of this technical field, for example, Japanese Patent Application Publication No. 2016-86489 has been known. Japanese Patent Application Publication No. 2016-86489 describes a configuration that measures the temperature, electric current, and voltage of each brush and the torque of a rotor, and increases the pressing force of the brush when a contact error between the rotor and the brush is caused, thereby maintaining the contact condition satisfactorily.

The brush and the slip ring used in the rotating machine, such as an electric generator and an electric motor, become electrically conductive while making sliding contact with each other. However, in the case of, for example, a turbine electric generator, when eccentricity or shaft vibration is caused during operation, or when the ambient environment including humidity and dust changes, a spark occurs at the sliding interface between the brush and the slip ring. This can cause a severe accident such as the unexpected stop of the machine, which requires the replacement of the brush and the slip ring, and the like. To prevent such an accident, it is desirable to detect spark early and accurately.

Japanese Patent Application Publication No. 2016-86489 discloses, as means for detecting a contact error between the metal rotor (slip ring) and the brush, a torque sensor for detecting the torque of the shaft of the slip ring, a current sensor for detecting the electric current flowing in the brush or the slip ring, a temperature sensor for measuring the temperature of the brush, and the like. However, all of the sensors indirectly detect a contact error between the slip ring and the brush, so that when the sensors are used for detecting the above-described spark occurring at the sliding interface, there is a fear of erroneous detection due to noise with the operation of the rotating machine or noise with spark, and the like. This makes precise spark detection difficult.

### SUMMARY OF THE INVENTION

Accordingly, an object of the present invention is to provide a spark detecting apparatus for devices using electric sliding contact, a spark detecting method for devices using electric sliding contact, a sliding error detecting apparatus for devices using electric sliding contact, and a sliding error detecting method for devices using electric sliding contact, in which in an electric machine having an electric sliding contact mechanism, a spark occurring in an electric sliding contact section is detected early and accurately, and further, a sliding error is detected and notified, so as to enable the unexpected stop avoidance and the static operation of the electric machine.

Also, another object of the present invention is to provide a spark reduction method for devices using electric sliding contact and a sliding error detecting method for devices using electric sliding contact, in which in an electric machine using an electric sliding contact mechanism, spark in an electric sliding contact section is reduced, so as to enable the unexpected stop avoidance and the static operation of the electric machine.

### Solution to Problem

To achieve the above objects, the present invention provides a spark detecting apparatus for devices using electric sliding contact, including a static part, a sliding part becoming electrically conductive while making sliding contact with the static part, a frequency filter selectively passing a voltage signal in a particular band, a volt meter electrically connected to the static part through the frequency filter, and a detecting apparatus for sliding condition determining the presence or absence of spark at the sliding interface between the static part and the sliding part. When a voltage signal detected by the volt meter exceeds a predetermined threshold value, it is determined that a spark has occurred.

Also, the present invention provides a spark detecting method for devices using electric sliding contact constituting an electric sliding contact mechanism in which a static part and a sliding part become electrically conductive while making sliding contact with each other. A voltage signal in a particular band of the static part is selectively detected through a frequency filter. When the detected voltage signal exceeds a predetermined threshold value, it is determined that a spark has occurred.

Also, the present invention provides a spark reduction method for devices using electric sliding contact using the spark detecting method for devices using electric sliding contact. When it is determined that a spark has occurred, the pressing force of the static part against the sliding part is adjusted to reduce spark.

Also, the present invention provides a sliding error detecting apparatus for devices using electric sliding contact including the spark detecting apparatus for devices using electric sliding contact. The detecting apparatus for sliding condition has a function of determining the sliding condition of the electric sliding contact based on the presence or absence of spark and the number of sparks within predetermined time.

Also, the present invention provides a sliding error detecting method for devices using electric sliding contact using the spark detecting method for devices using electric sliding contact. The sliding condition of the electric sliding contact is determined based on the presence or absence of spark occurrence and the number of sparks within predetermined time.

According to the present invention, it is possible to achieve the spark detecting apparatus for devices using electric sliding contact and the spark detecting method for devices using electric sliding contact, in which in the electric machine using the electric sliding contact mechanism, a spark occurring in the electric sliding contact section is detected early and accurately, so as to enable the unexpected stop avoidance and the static operation of the electric machine.

Also, it is possible to achieve the spark reduction method for devices using electric sliding contact, in which in the electric machine using the electric sliding contact mechanism, spark in the electric sliding contact section is reduced, so as to enable the unexpected stop avoidance and the static operation of the electric machine.

Also, the sliding condition of the electric sliding contact is determined based on the presence or absence of spark and the number of spark occurrences within predetermined time. This enables sliding error detection and error prevention and solution very early.

Problems, configurations, and effects other than the above will be apparent from the description of the following embodiments.

### BRIEF DESCRIPTION OF THE DRAWINGS

Fig. 1 is a diagram illustrating a spark detecting apparatus according to an embodiment of the present invention (a first embodiment);
Fig. 2 is a diagram illustrating a spark detecting apparatus according to an embodiment of the present invention (a second embodiment);
Fig. 3 is a diagram illustrating a spark detecting apparatus according to an embodiment of the present invention (a third embodiment);
Fig. 4 is a diagram illustrating a spark detecting apparatus according to an embodiment of the present invention (a fourth embodiment);
Fig. 5 is a diagram illustrating a spark detecting apparatus according to an embodiment of the present invention (a fifth embodiment);
Fig. 6 is a diagram illustrating a spark detecting apparatus according to an embodiment of the present invention (a sixth embodiment);
Fig. 7 is a diagram illustrating a spark detecting apparatus according to an embodiment of the present invention (a seventh embodiment);
Fig. 8 is a diagram illustrating a spark detecting apparatus according to an embodiment of the present invention (an eighth embodiment);
Fig. 9 is a diagram illustrating the schematic configuration of a representative rotating machine;
Fig. 10 is a cross-sectional view taken along line A-A' of Fig. 9; and
Fig. 11 is a diagram illustrating a sliding error detecting apparatus according to an embodiment of the present invention (a ninth embodiment).

### DETAILED DESCRIPTION OF THE PREFERRED EMBODIMENTS

Embodiments of the present invention will now be described with reference to the drawings. It should be noted that the same configurations in the respective drawings are indicated by similar reference signs and the detailed description of overlapped portions is omitted.

### First Embodiment

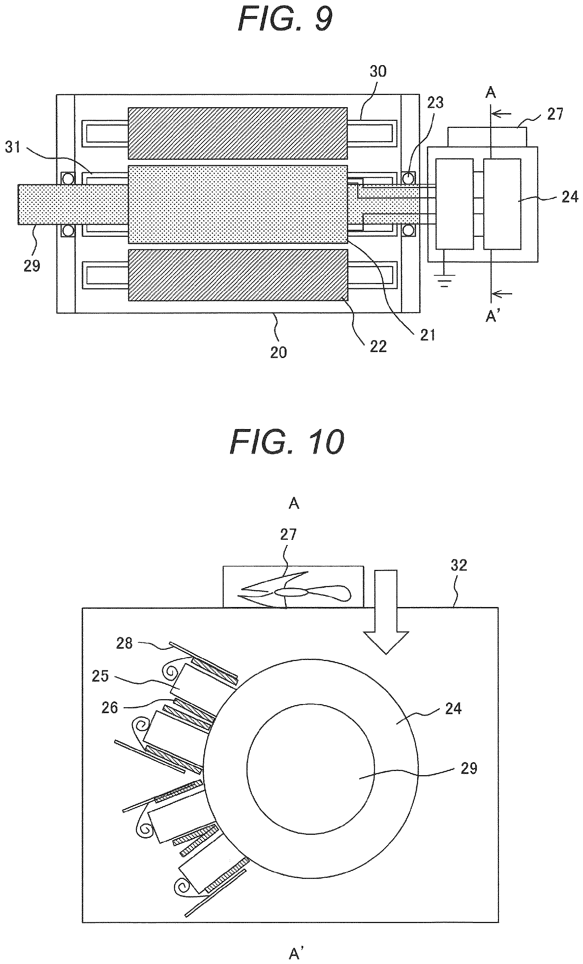

First, referring to Figs. 9 and 10, an electric machine having an electric sliding contact mechanism targeted by the present invention will be described. Fig. 9 is a diagram illustrating the schematic configuration of a representative rotating machine, and here, the rotating machine, such as an electric generator and an electric motor, is assumed. Fig. 10 illustrates a cross section taken along line A-A' of Fig. 9.

It should be noted that the application range of the present invention is not limited to the rotating machine, and also includes, for example, the electric machine having the electric sliding contact mechanism, such as a trolley wire and a pantograph for electric railroad described at the beginning herein, which straightly slides. Thus, herein, a slip ring and a brush are called a sliding part and a static part, respectively. In addition, to distinguish from these configurations, the so-called stator and the so-called rotor of the rotating machine are called a rotating machine stator and a rotating machine rotor, respectively.

As illustrated in Fig. 9, the rotating machine targeted by the present invention includes, in a body frame 20, a rotating machine rotor 21, and a rotating machine stator 22 disposed opposite the rotating machine rotor 21 with a predetermined gap. The rotating machine rotor 21 includes a rotating machine rotor winding 31, and the rotating machine stator 22 includes a rotating machine stator winding 30. The rotating machine rotor winding 31 is electrically connected to a slip ring 24 described later. The rotating machine rotor 21 includes a rotating shaft 29 that protrudes from the body frame 20. The rotating shaft 29 is rotatably supported by bearings 23 with respect to the body frame 20. The rotating shaft 29 has one end at which the slip ring 24 is mounted. It should be noted that a helical groove (not illustrated) may be disposed on the slip ring 24 so that a brush 25 comes into contact with the entire surface of the slip ring 24.

As the holding part for the brush 25, a brush holder 26 is mounted on the slip ring 24. It should be noted that Fig. 10 illustrates an example in which four sets of brushes 25 and brush holders 26 are disposed on the slip ring 24. Each of the brush holders 26 is tubular, and is opened at both ends, so that the brush 25 can be easily mounted in and removed from the brush holder 26. A gap is provided between the brush 25 and the brush holder 26, so that the brush 25 is slidably held with respect to the brush holder 26. In addition, the brush 25 is pressed against the slip ring 24 by a pressing part 28 with a predetermined pressing force.

The brush 25 and the slip ring 24 are accommodated in a housing 32. A cooling fan 27 is disposed on the housing 32, and promotes the cooling of the interior of the housing 32 for preventing the temperature increase of the brush 25. Fig. 10 illustrates an example in which as the pressing part 28, a winding spring with a constant load is used so that its pressing force does not change even when the brush 25 wears, the pressing part 28 being fixed by the side surface of the brush holder 26. It should be noted that in addition to the winding spring as illustrated in Fig. 10, a coil spring and the like may be used as the pressing part 28. In addition, to increase the pressing force of the brush 25 by the pressing part 28, an auxiliary spring may be additionally disposed.

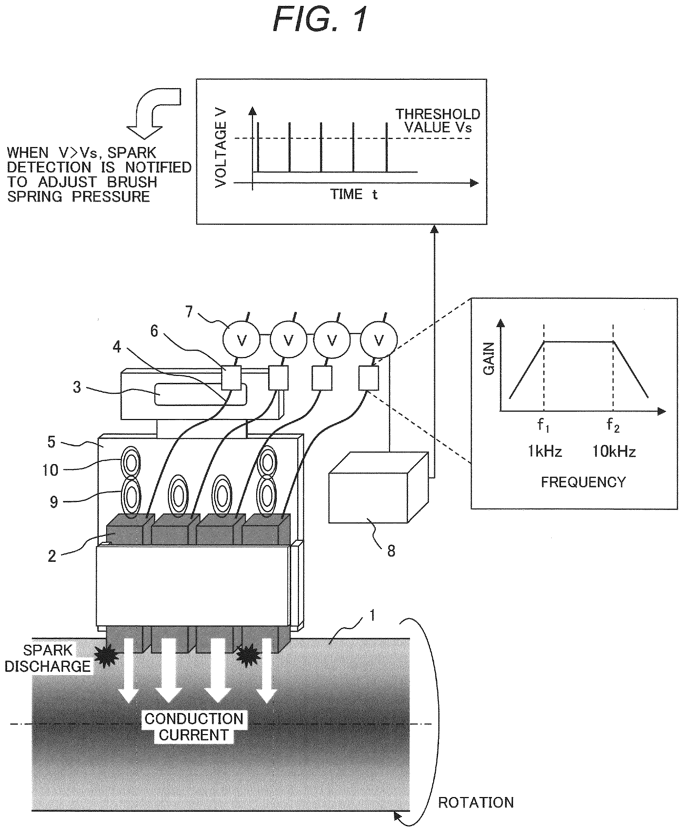

Next, referring to Fig. 1, a spark detecting apparatus for devices using electric sliding contact, a spark detecting method for devices using electric sliding contact, and a spark reduction method for devices using electric sliding contact according to a first embodiment will be described. In this embodiment, as a combination of different electric components of the electric sliding contact mechanism, a slip ring (sliding part) 1 and a brush (static part) 2 are used. It should be noted that the present invention is applicable, as the combination of different electric components, to a trolley wire and a pantograph for electric railroad or the stator and the movable part of a switch gear, in other fields.

As illustrated in Fig. 1, in the electric sliding contact mechanism of the rotating machine according to this embodiment, four brushes (static parts) 2 for current conduction come into contact with the surface of the slip ring (sliding part) 1, so that the brushes 2 and the slip ring 1 rotate and slide on each other while becoming electrically conductive. The brushes 2 are held in a brush holder 5. It should be noted that the brush holder 5 has a handle 3 that is used for mounting and removing the brush holder 5 to enable the four brushes 2 to be replaceable at the same time. Each lead wire 4 for electric conduction is connected to one end of each of the brushes 2 (the end on the opposite side of the sliding surface of the brush 2 with respect to the slip ring 1).

Here, each frequency filter 6 and each volt meter 7 are electrically connected to the lead wire 4 for each of the brushes 2. The volt meter 7 is disposed at one end of the brush 2 (the end on the opposite side of the sliding surface of the brush 2 with respect to the slip ring 1) through the frequency filter 6. The arc discharge (spark discharge) voltage generated at the sliding interface between the slip ring 1 and the brush 2 is pulse-like, the pulse width is on the order of 0.1 ms to several ms, and the pulse height (voltage wave height) is on the order of 10 V to 20 V. The frequency filter 6 is a so-called band pass filter that selectively passes a voltage signal in a particular band.

As illustrated in Fig. 1, for the passing band of the frequency filter 6, for example, f₁ = 1 kHz to f₂ = 10 kHz. The voltage that has passed without being filtered through the frequency filter 6 is measured by the volt meter 7, and is transmitted to a detecting apparatus for sliding condition 8. The detecting apparatus for sliding condition 8 reads the hysterical waveform of voltage of each of the brushes 2. The detecting apparatus for sliding condition 8 includes the function of determining the presence or absence of spark at the sliding interface between the slip ring 1 and the brush 2 based on a signal inputted, and a notifying function for notifying spark detection to the outside when it is determined that a spark has occurred.

And, for the brush in which a voltage signal V exceeds, for example, a threshold value Vₛ = 5 V (V > Vₛ), spark detection notification is provided. The operator who has received the spark detection notification removes the brush holder 5 containing the brush 2 from the slip ring 1 by using the handle 3, and performs the replacement of an original spring 9 originally disposed in the brush holder 5 with a high rigidity spring, the addition of an auxiliary spring 10, and the like, thereby adjusting the brush spring pressure, that is, the pressing force of the brush 2 against the slip ring 1. Thereafter, the whole brush holder 5 is mounted on the slip ring 1 again.

As described above, the spark detecting apparatus for devices using electric sliding contact according to this embodiment includes, in the rotating machine in which two different electric components slide on each other while becoming electrically conductive each other, the frequency filter 6 (band pass filter) passing a voltage signal in a particular band and the volt meter 7, which are disposed for each of the brushes 2 to detect a spark, that is, arc discharge, and the detecting apparatus for sliding condition 8 for detecting spark when the voltage value exceeds the set threshold value (Vₛ).

It should be noted that as the external factor superimposed on the brush voltage (noise), there is an electro-magnetic wave (on the order of several hundred MHz to several GHz) caused by voltage fluctuation in the rotating cycle of the rotating machine (for example, 20 ms when the rotating speed is 3,000 rpm) or the partial discharge of an insulating part.

Accordingly, in this embodiment, the brush voltage V is measured by the volt meter 7 through the band pass filter (frequency filter 6) having, for example, 1 kHz to 10 kHz and passing a voltage (voltage signal) only in the arc discharge band, except for the above superimposed factor (external factor superimposed). Then, when the brush voltage V exceeds, for example, the threshold value Vₛ = 5 V, the detecting apparatus for sliding condition 8 provides notification that a spark has been detected in the particular brush 2. At this time, the brush pressing spring (original spring 9) disposed in the brush holder 5 holding the brush 2 in which the spark has occurred is replaced with a high rigidity spring, or the auxiliary spring (auxiliary spring 10) is added. Thus, the brush pressing against the slip ring 1 is increased to return the brush 2 into the condition in which no spark occurs.

According to the present invention, sparks can be detected early and accurately. This achieves immediate solution for the deterioration prevention of the electric sliding contact, such as the slip ring, the collector ring, and the brush, and the operation life improvement (static operation) and the unexpected stop avoidance of the rotating machine.

### Second Embodiment

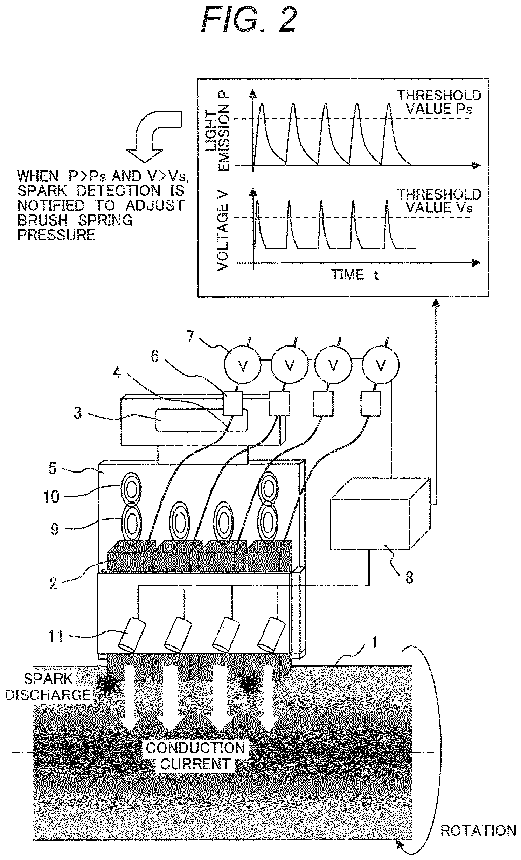

Referring to Fig. 2, a spark detecting apparatus for devices using electric sliding contact, a spark detecting method for devices using electric sliding contact, and a spark reduction method for devices using electric sliding contact according to a second embodiment will be described. As illustrated in Fig. 2, the spark detecting apparatus of this embodiment is different from the spark detecting apparatus of the first embodiment in that, in addition to the configuration of the first embodiment, each photo-multiplier tube 11 is disposed for each of the brushes 2. The photo-multiplier tube 11 for detecting the light emission of a spark (arc discharge) is disposed for each of the brushes 2 and near the sliding interface of the brush holder 5, measures an optical signal P with the detection of the voltage V of the spark (arc discharge) by the volt meter 7 through the frequency filter 6, and transmits the optical signal P to the detecting apparatus for sliding condition 8.

Then, for the brush 2 in which V > Vₛ and P > Pₛ (Pₛ: predetermined threshold value), the detecting apparatus for sliding condition 8 provides spark detection notification. The mounting and removal of the brush holder 5 and the brush spring pressure adjustment (the adjustment of the pressing force of the brush 2 against the slip ring 1) thereafter are the same as the method described in the first embodiment.

As described above, in the spark detecting apparatus for devices using electric sliding contact according to this embodiment, in addition to the configuration of the first embodiment, each photo-multiplier tube 11 is disposed for each of the brushes 2 and near the sliding interface of the brush holder 5, and detects the optical signal P with the detection of the voltage V. Then, the detecting apparatus for sliding condition 8 to which the optical signal threshold value Pₛ is set provides spark detection notification when V > Vₛ and P > Pₛ.

According to this embodiment, the spark (arc discharge) is detected by both the voltage signal V and the optical signal P. This further improves the detection accuracy of spark.

It should be noted that this embodiment is not necessarily limited to the case where both the voltage signal V and the optical signal P are generated synchronously, and the case where the optical signal P is generated within the predetermined period before and after time at which the voltage signal V is generated is also included in the range of the invention. This is because the voltage signal V and the optical signal P may be different in traveling speed and detecting speed due to their properties. This is ditto for the following embodiments.

### Third Embodiment

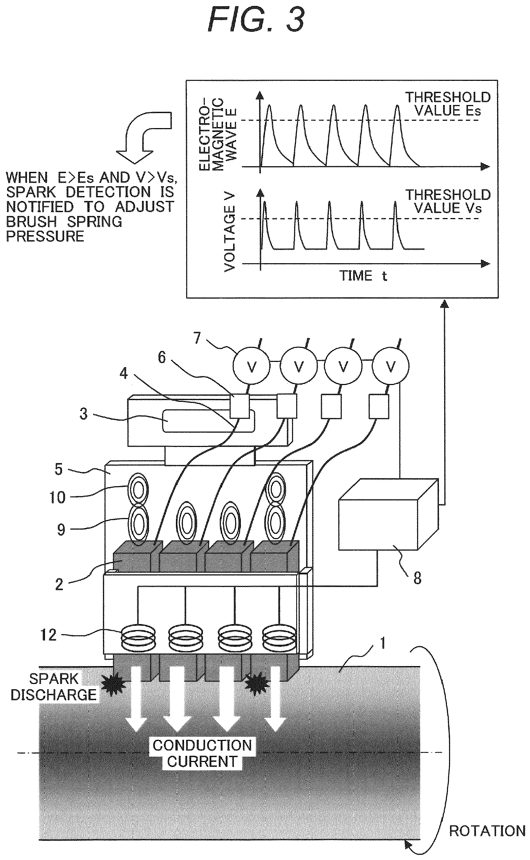

Referring to Fig. 3, a spark detecting apparatus for devices using electric sliding contact, a spark detecting method for devices using electric sliding contact, and a spark reduction method for devices using electric sliding contact according to a third embodiment will be described. As illustrated in Fig. 3, the spark detecting apparatus of this embodiment is different from the spark detecting apparatus of the first embodiment in that, in addition to the configuration of the first embodiment, each electro-magnetic wave antenna 12 is disposed for each of the brushes 2. In this embodiment, the electro-magnetic wave antenna 12, such as a loop antenna and a dipole antenna, is used in place of the photo-multiplier tube 11 described in the second embodiment. The electro-magnetic wave antenna 12 for detecting an electro-magnetic wave emitted with the occurrence of a spark (arc discharge) is disposed for each of the brushes 2 and near the sliding interface of the brush holder 5, measures an electro-magnetic wave signal E with the detection of the voltage V of the spark (arc discharge) by the volt meter 7 through the frequency filter 6, and transmits the electro-magnetic wave signal E to the detecting apparatus for sliding condition 8.

And, for the brush 2 in which V > Vₛ and E > Eₛ (Eₛ: predetermined threshold value), the detecting apparatus for sliding condition 8 provides spark detection notification. The mounting and removal of the brush holder 5 and the brush spring pressure adjustment (the adjustment of the pressing force of the brush 2 against the slip ring 1) thereafter are the same as the method described in the first embodiment.

As described above, in the spark detecting apparatus for devices using electric sliding contact according to this embodiment, in addition to the configuration of the first embodiment, each electro-magnetic wave antenna 12 is disposed for each of the brushes 2 and near the sliding interface of the brush holder 5, and detects the electro-magnetic wave signal E with the detection of the voltage V. Then, the detecting apparatus for sliding contact 8 to which the electro-magnetic wave signal threshold value Eₛ is set provides spark detection notification when V > Vₛ and E > Eₛ.

According to this embodiment, the spark (arc discharge) is detected by both the voltage signal V and the electro-magnetic wave signal E. This further improves the detection accuracy of spark occurrence. In addition, the detection means is changed from the photo-multiplier tube to the electro-magnetic wave antenna. This makes the detection configuration of this embodiment more inexpensive than the detection configuration of the second embodiment.

### Fourth Embodiment

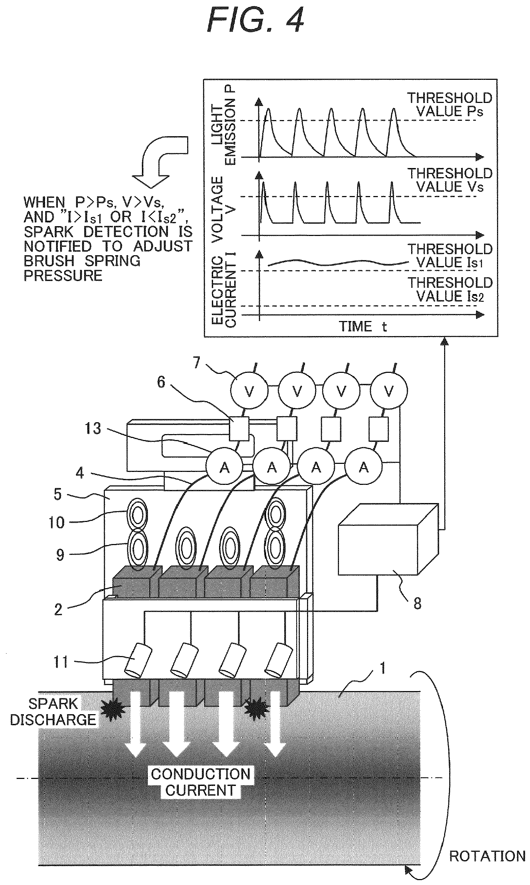

Referring to Fig. 4, a spark detecting apparatus for devices using electric sliding contact, a spark detecting method for devices using electric sliding contact, and a spark reduction method for devices using electric sliding contact according to a fourth embodiment will be described. As illustrated in Fig. 4, the spark detecting apparatus of this embodiment is different from the spark detecting apparatus of the second embodiment in that, in addition to the configuration of the second embodiment, each ammeter 13 is disposed for each of the brushes 2. The ammeter 13 for detecting the change in electric current (the increase and decrease in the value of the electric current) with the occurrence of a spark (arc discharge), like a surge current is connected to the lead wire 4 between one end of the brush 2 and the frequency filter 6, measures a current signal I with the detection of the voltage V of the spark (arc discharge) by the volt meter 7 through the frequency filter 6 and the detection of the optical signal P by the photo-multiplier 11, and transmits the current signal I to the detecting apparatus for sliding condition 8.

And, for the brush 2 in which V > Vₛ, P > Pₛ, and "I > Iₛ₁ or I < Iₛ₂" (Iₛ₁: predetermined upper limit threshold value, Iₛ₂: predetermined lower limit threshold value), the detecting apparatus for sliding condition 8 provides spark detection notification. The mounting and removal of the brush holder 5 and the brush spring pressure adjustment (the adjustment of the pressing force of the brush 2 against the slip ring 1) thereafter are the same as the method described in the first embodiment.

As described above, in the spark detecting apparatus for devices using electric sliding contact according to this embodiment, in addition to the configuration of the second embodiment, each ammeter 13 is disposed for each of the brushes 2, and detects the current signal I with the detection of the voltage V and the optical signal P. Then, the detecting apparatus for sliding condition 8 to which the upper limit Iₛ₁ and the lower limit Iₛ₂ are set as the current signal threshold values provides spark detection notification when "I > Iₛ₁ or I < Iₛ₂" as well as V > Vₛ and P > Pₛ.

Here, the reason why the upper limit (Iₛ₁) and the lower limit (Iₛ₂) are set as the current signal threshold values will be described. When an excessively large electric current flows in the particular brush 2 (when I > Iₛ₁), the temperature of the brush 2 (the sliding interface temperature) increases to make the risk of spark higher. On the other hand, an excessively small electric current flows in the particular brush 2 (when I < Iₛ₂), unstable contact due to the vibration (chattering) of the brush 2 with respect to the slip ring 1 or the non-securement of the real contacting point (conducting point) between the slip ring 1 and the brush 2 occurs to make the risk of spark higher.

According to this embodiment, in addition to the voltage signal V and the optical signal P, the current signal I is detected. This further improves the detection accuracy of spark.

### Fifth Embodiment

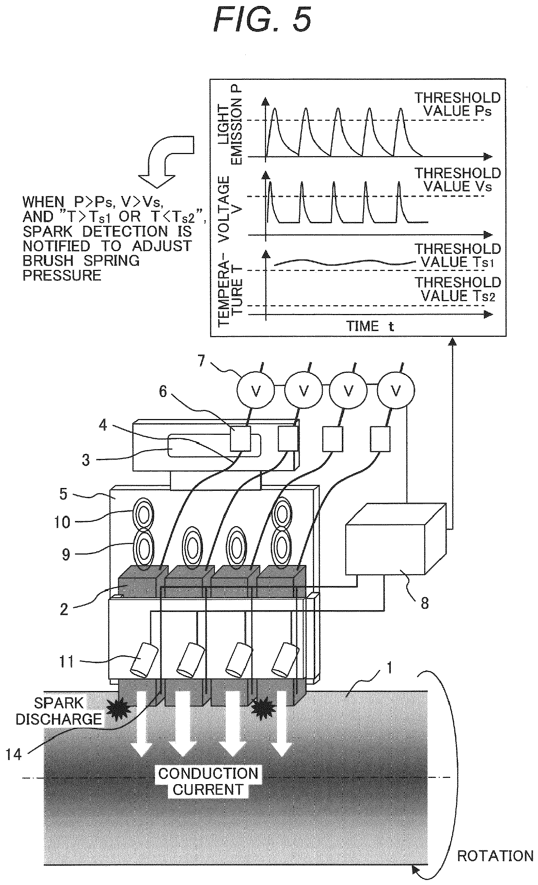

Referring to Fig. 5, a spark detecting apparatus for devices using electric sliding contact, a spark detecting method for devices using electric sliding contact, and a spark reduction method for devices using electric sliding contact according to a fifth embodiment will be described. As illustrated in Fig. 5, the spark detecting apparatus of this embodiment is different from the spark detecting apparatus of the second embodiment in that, in addition to the configuration of the second embodiment, each temperature gauge 14 is disposed for each of the brushes 2. In this embodiment, in place of the ammeter 13 described in the fourth embodiment, the temperature gauge 14, such as a thermo-coupler, is used. The temperature gauge 14 for detecting the temperature change near the sliding interface with the occurrence of a spark (arc discharge) is disposed for each of the brushes 2 and near the sliding interface of the brush holder 5, measures a temperature signal T with the detection of the voltage V of the spark (arc discharge) by the volt meter 7 through the frequency filter 6 and the detection of the optical signal P by the photo-multiplier 11, and transmits the temperature signal T to the detecting apparatus for sliding condition 8.

Then, for the brush 2 in which V > Vₛ, P > Pₛ, and "T > Tₛ₁ or T < Tₛ₂", the detecting apparatus for sliding condition 8 provides spark detection notification. The mounting and removal of the brush holder 5 and the brush spring pressure adjustment (the adjustment of the pressing force of the brush 2 against the slip ring 1) thereafter are the same as the method described in the first embodiment.

As described above, in the spark detecting apparatus for devices using electric sliding contact according to this embodiment, in addition to the configuration of the second embodiment, each temperature gauge 14, such as a thermo-coupler, is disposed for each of the brush 2, and detects the temperature signal T with the detection of the voltage V and the optical signal P. Then, the detecting apparatus for sliding condition 8 to which the upper limit Tₛ₁ and the lower limit Tₛ₂ are set as the temperature signal threshold values provides spark detection notification when "T > Tₛ₁ or T < Tₛ₂" as well as V > Vₛ and P > Pₛ.

Here, the reason why the upper limit (Tₛ₁) and the lower limit (Tₛ₂) are set as the temperature signal threshold values will be described. When the temperature of the particular brush 2 is high (T > Tₛ₁), as in the description of the fourth embodiment, an excessively large electric current flows in the brush 2 to make the risk of spark higher. On the other hand, when the temperature of the particular brush 2 is low (T < Tₛ₂), as in the description of the fourth embodiment, the real contacting point (conducting point) between the slip ring 1 and the brush 2 is not secured so that the electric current is unlikely to flow, resulting in unstable contact which makes the risk of spark higher.

According to this embodiment, in addition to the voltage signal V and the optical signal P, the temperature signal T is detected. This further improves the detection accuracy of spark.

### Sixth Embodiment

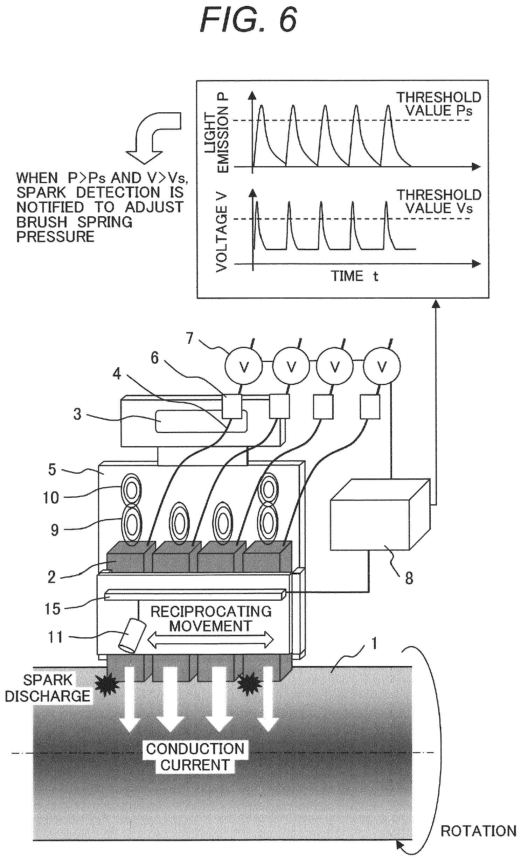

Referring to Fig. 6, a spark detecting apparatus for devices using electric sliding contact, a spark detecting method for devices using electric sliding contact, and a spark reduction method for devices using electric sliding contact according to a sixth embodiment will be described. The spark detecting apparatus of this embodiment is different from the spark detecting apparatus of the second embodiment in that in the configuration of the second embodiment, each photo-multiplier tube 11 (in Fig. 2, four photo-multiplier tubes 11) is disposed for each of the brushes 2, whereas as illustrated in Fig. 6, in the spark detecting apparatus of this embodiment, one photo-multiplier tube 11 is disposed near the sliding interface of the brush holder 5 via a slider 15. The photo-multiplier tube 11 is mounted above the brush holder 5 and via the reciprocating movement machine 15, such as a slider, measures the optical signal P while moving above the side surface of the brush holder 5 and while reciprocatingly moving across the installation range of the plurality of brushes 2, and transmits the optical signal P to the detecting apparatus for sliding condition 8.

And, for the brush 2 in which V > Vₛ and P > Pₛ, the detecting apparatus for sliding condition 8 provides spark detection notification. The mounting and removal of the brush holder 5 and the brush spring pressure adjustment (the adjustment of the pressing force of the brush 2 against the slip ring 1) thereafter are the same as the method described in the first embodiment.

As described above, in the spark detecting apparatus for devices using electric sliding contact according to this embodiment, in place of the configuration according to the second embodiment in which each photo-multiplier tube 11 is disposed for each of the brushes 2, the reciprocating movement machine 15, such as a slider, reciprocatingly moving one photo-multiplier tube 11 above the brush holder 5 is disposed, and the photo-multiplier tube 11 detects the optical signal P with respect to the plurality of brushes 2 while moving.

According to this embodiment, the plurality of brushes 2 are managed by one photo-multiplier tube 11. This makes the detection configuration of this embodiment more inexpensive than the detection configuration of the second embodiment.

It should be noted that the detection of a spark via the reciprocating movement machine 15, such as a slider, is applicable, not only to the case where the photo-multiplier tube 11 is used as the spark detecting means, but also to, for example, the case where the electro-magnetic wave antenna 12 described in the third embodiment (Fig. 3) is used, and the like.

### Seventh Embodiment

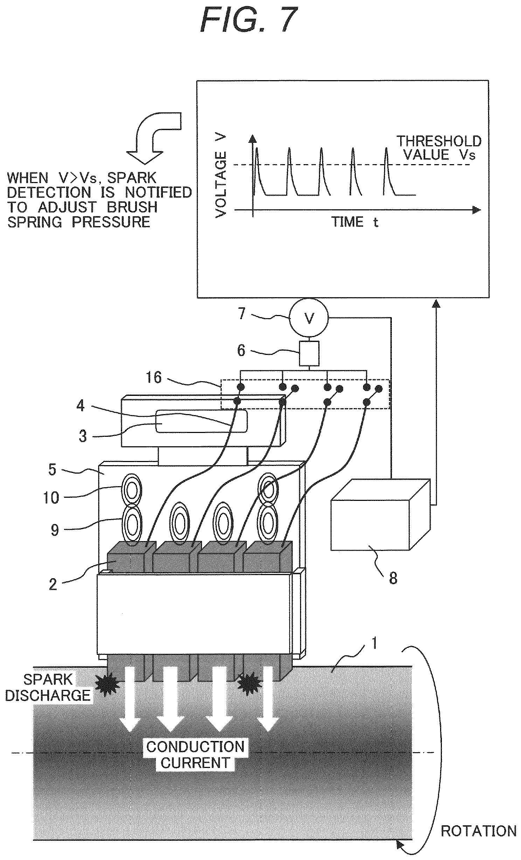

Referring to Fig. 7, a spark detecting apparatus for devices using electric sliding contact, a spark detecting method for devices using electric sliding contact, and a spark reduction method for devices using electric sliding contact according to a seventh embodiment will be described. The spark detecting apparatus of this embodiment is different from the spark detecting apparatus of the first embodiment in that in the configuration of the first embodiment, each frequency filter 6 and each volt meter 7 are connected to each of the brushes 2, whereas as illustrated in Fig. 7, in the spark detecting apparatus of this embodiment, a set of the frequency filter 6 and the volt meter 7 is connected to a plurality of brushes 2 (here, four brushes 2) through switches (relays) 16. One frequency filter 6 and one volt meter 7 are disposed for the plurality of brushes 2. The switches (relays) 16 are disposed between the frequency filter 6 and the lead wires 4 for the brushes 2. The connections of the frequency filter 6 and the lead wires 4 are sequentially switched to measure the voltage signal V, and the voltage signal V is then transmitted to the detecting apparatus for sliding condition 8.

And, for the brush 2 in which V > Vₛ, the detecting apparatus for sliding condition 8 provides spark detection notification. The mounting and removal of the brush holder 5 and the brush spring pressure adjustment (the adjustment of the pressing force of the brush 2 against the slip ring 1) thereafter are the same as the method described in the first embodiment.

As described above, in the spark detecting apparatus for devices using electric sliding contact according to this embodiment, in place of the configuration of the first embodiment in which each frequency filter 6 and each volt meter 7 are disposed for each of the brushes 2, one frequency filter 6 and one volt meter 7 are disposed for the plurality of brushes 2, and the switches (relays) 16 are disposed between the frequency filter 6 and the lead wires 4 for the brush 2, so that the connections of the frequency filter 6 and the lead wires 4 are sequentially switched.

According to this embodiment, the plurality of brushes 2 are managed by one frequency filter 6 and one volt meter 7. This makes the detection configuration of this embodiment more inexpensive than the detection configuration of the first embodiment.

### Eighth Embodiment

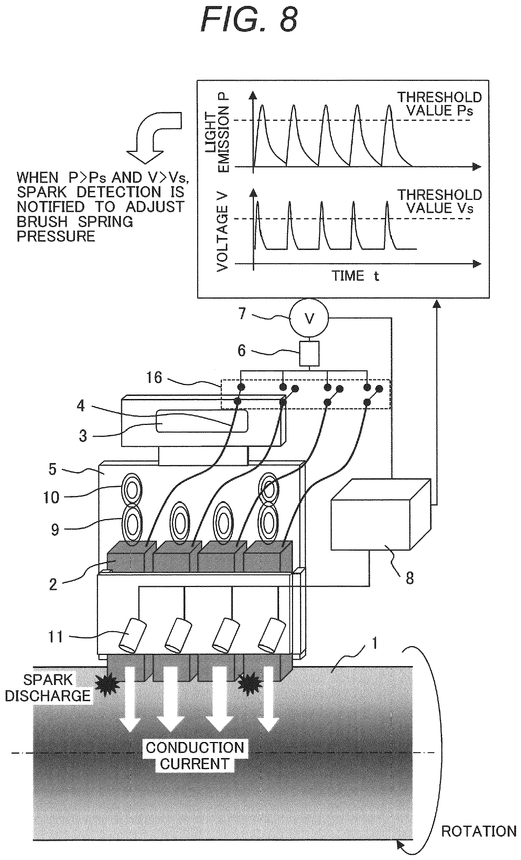

Referring to Fig. 8, a spark detecting apparatus for devices using electric sliding contact, a spark detecting method for devices using electric sliding contact, and a spark reduction method for devices using electric sliding contact according to an eighth embodiment will be described. The spark detecting apparatus of this embodiment is different from the spark detecting apparatus of the second embodiment in that in the configuration of the second embodiment, each frequency filter 6 and each volt meter 7 are connected to each of the brushes 2, whereas as illustrated in Fig. 8, in the spark detecting apparatus of this embodiment, a set of the frequency filter 6 and the volt meter 7 is connected to a plurality of brushes 2 (here, four brushes 2) through the switches (relays) 16. One frequency filter 6 and one volt meter 7 are disposed for the plurality of brushes 2. The switches (relays) 16 are disposed between the frequency filter 6 and the lead wires 4 for the brushes 2. The connections of the frequency filter 6 and the lead wires 4 are sequentially switched to measure the voltage signal V, and the voltage signal V is then transmitted to the detecting apparatus for sliding condition 8.

And, for the brush 2 in which V > Vₛ and P > Pₛ, the detecting apparatus for sliding condition 8 provides spark detection notification. The mounting and removal of the brush holder 5 and the brush spring pressure adjustment (the adjustment of the pressing force of the brush 2 against the slip ring 1) thereafter are the same as the method described in the first embodiment.

As described above, in the spark detecting apparatus for devices using electric sliding contact according to this embodiment, in place of the configuration of the second embodiment in which each frequency filter 6 and each volt meter 7 are disposed for each of the brushes 2, one frequency filter 6 and one volt meter 7 are disposed for the plurality of the brushes 2, and the switches (relays) 16 are disposed between the frequency filter 6 and the lead wires 4 for the brushes 2, so that the connections of the frequency filter 6 and the lead wires 4 are sequentially switched.

According to this embodiment, the plurality of brushes 2 are managed by one frequency filter 6 and one volt meter 7. This makes the detection configuration of this embodiment more inexpensive than the detection configuration of the second embodiment.

### Ninth Embodiment

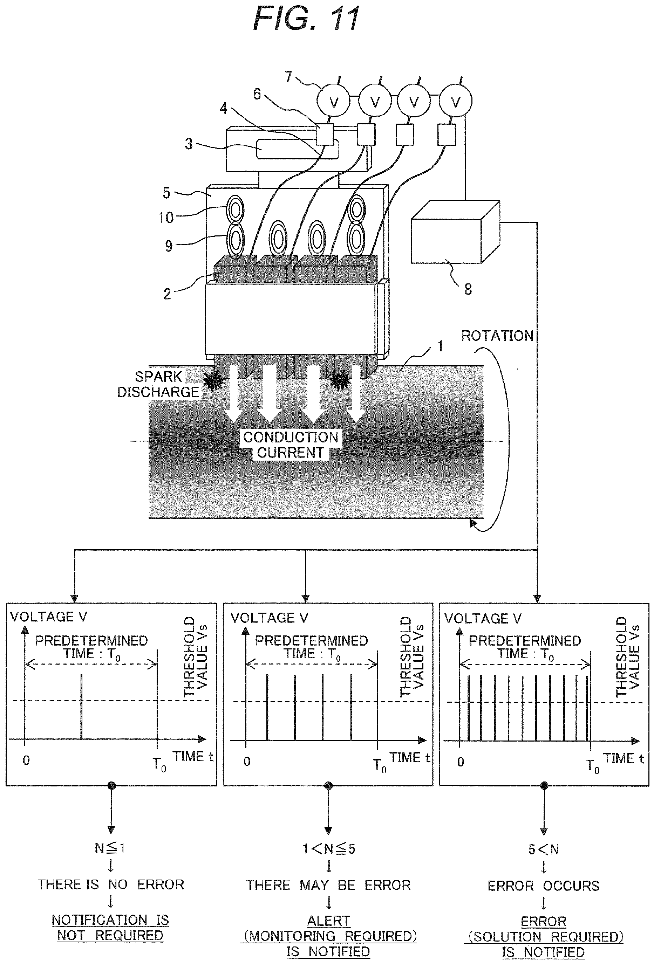

Referring to Fig. 11, a sliding error detecting apparatus for devices using electric sliding contact and a sliding error detecting method for devices using electric sliding contact according to a ninth embodiment will be described. In the configuration of this embodiment, the detecting apparatus for sliding condition 8 includes the function of counting, within predetermined time T₀, the number of times in which the voltage signal is V > Vₛ, that is, the number of times in which the voltage signal exceeds the threshold value Vₛ, to select (determine), according to the number of times, any one of "notification is not required", "alert (monitoring required) is notified", and "error (solution required) is notified".

Here, the predetermined time T₀ is set to 100 ms corresponding to five rotations where, for example, the rotating cycle of the slip ring 1 is 20 ms (3,000 rpm). The above notification selection (notification determination) is defined in, for example, the following three ways.

In the first way, when the number of times N in which the voltage signal exceeds the threshold value Vₛ within the predetermined time T₀ is N ≤ 1 (the number of times N is one or less within 100 ms), it is determined that there is no error because the spark occurs irrespective of the sliding interface and accidentally, thereby providing no notification. In the second way, when 1 < N ≤ 5, it is determined that there may be a sliding error because the spark occurs periodically due to a contact error between the slip ring 1 and the brush 2 caused by vibration and the like during the rotation of the slip ring 1, thereby providing alert notification (monitoring required). In the third way, when 5 < N, it is determined that a sliding error is caused with apparent spark due to the vibration of the slip ring 1, the roughening of the sliding surface, and the like, thereby providing error notification (solution required). When solution is required, as described in the first embodiment, the replacement of the original spring 9 with a high rigidity spring, the addition of the auxiliary spring 10, and the like are performed, thereby adjusting the brush spring pressure, that is, the pressing force of the brush 2 against the slip ring 1.

It should be noted that in this embodiment (Fig. 11), only the voltage signal within the predetermined time T₀ is to be detected, but, like the above respective embodiments, not only the voltage signal, but also the optical signal and the electro-magnetic wave signal, may be detected within the T₀ at the same time. Thus, the accuracy of the sliding error detection is improved.

According to this embodiment, the sliding error detection and the error prevention and solution can be achieved very early, and in addition to the operation life improvement (static operation) and the unexpected stop avoidance of the rotating machine, the component replacement and the replacing period can be previously grasped.

It should be noted that the present invention is not limited to the above embodiments, and includes various modifications. For example, the above embodiments have been described in detail for easily understanding the present invention, and do not necessarily include all the described configurations. In addition, part of the configuration of one embodiment can be replaced with the configurations of other embodiments, and the configuration of one embodiment can be added with the configurations of other embodiments. Further, part of the configuration of each of the embodiments can be subjected to addition, deletion, and replacement with respect to other configurations.

### Reference Signs List

1 ... slip ring (sliding part), 2 ... brush (static part), 3 ... handle, 4 ... lead wire, 5 ... brush holder, 6 ... frequency filter, 7 ... volt meter, 8 ... detecting apparatus for sliding condition, 9 ... original spring, 10 ... auxiliary spring, 11 ... photo-multiplier tube, 12 ... electro-magnetic wave antenna, 13 ... ammeter, 14 ... temperature gauge, 15 ... slider (reciprocating movement machine), 16 ... switch (relay), 20 ... body frame, 21 ... rotating machine rotor, 22 ... rotating machine stator, 23 ... bearing, 24 ... slip ring, 25 ... brush, 26 ... brush holder, 27 ... cooling fan, 28 ... pressing part, 29 ... rotating shaft, 30 ... rotating machine stator wiring, 31 ... rotating machine rotor winding, 32 ... housing

## Claims

1. A spark detecting apparatus for devices using electric sliding contact comprising:
a static part (2);
a sliding part (1) becoming electrically conductive while making sliding contact with the static part (2);
a frequency filter (6) selectively passing a voltage signal in a particular band;
a volt meter (7) electrically connected to the static part (2) through the frequency filter (6);
**characterized in that**
the spark detecting apparatus has a detecting apparatus for sliding condition (8) determining the presence or absence of spark at the sliding interface between the static part (2) and the sliding part (1), and
when a voltage signal detected by the volt meter (7) exceeds a predetermined threshold value, it is determined that a spark has occurred.

2. A spark detecting method for devices using electric sliding contact constituting an electric sliding contact mechanism in which a static part (2) and a sliding part (1) become electrically conductive while making sliding contact with each other,
**characterized in that**
a voltage signal in a particular band of the static part is selectively detected through a frequency filter (6), and
when the detected voltage signal exceeds a predetermined threshold value, it is determined that a spark has occurred.

3. The spark detecting apparatus or method according to claim 1 or 2, wherein
a light emission detecting apparatus (11) is disposed near the sliding interface between the static part (2) and the sliding part (1), the light emission detecting apparatus (11) detecting the light emission of a spark, and
when an optical signal detected by the light emission detecting apparatus (11) exceeds a predetermined threshold value and the detected voltage signal exceeds a predetermined threshold value, it is determined that a spark has occurred.

4. The spark detecting apparatus or method according to claim 1 or 2, wherein
an electro-magnetic wave detecting apparatus (12) is disposed near the sliding interface between the static part (2) and the sliding part (1), the electro-magnetic wave detecting apparatus (12) detecting an electro-magnetic wave emitted from a spark, and
when an electro-magnetic wave signal detected by the electro-magnetic wave detecting apparatus (12) exceeds a predetermined threshold value and the detected voltage signal exceeds a predetermined threshold value, it is determined that a spark has occurred.

5. The spark detecting apparatus or method according to claim 3, wherein
an ammeter (13) is disposed between the static part (2) and the frequency filter (6), and
when a current signal detected by the ammeter (13) exceeds a predetermined threshold value range, an optical signal detected by the light emission detecting apparatus (11) exceeds a predetermined threshold value, and the detected voltage signal exceeds a predetermined threshold value, it is determined that a spark has occurred.

6. The spark detecting apparatus or method according to claim 3, wherein
a temperature gauge (14) is disposed near the sliding interface between the static part (2) and the sliding part (1), and
when a temperature signal detected by the temperature gauge (14) exceeds a predetermined threshold value range, an optical signal detected by the light emission detecting apparatus (11) exceeds a predetermined threshold value, and the detected voltage signal exceeds a predetermined threshold value, it is determined that a spark has occurred.

7. The spark detecting apparatus or method according to claim 3, wherein
a plurality of the static parts (2) are installed,
the light emission detecting apparatus (11) is disposed to a reciprocating movement device (15) movable across the installation range of the plurality of the static parts (2), and
the light emission detecting apparatus (11) detects the light emission of a spark while reciprocatingly moving in the installation range of the plurality of the static parts (2).

8. The spark detecting apparatus or method according to claim 4, wherein
a plurality of the static parts (2) are installed,
the electro-magnetic wave detecting apparatus (12) is disposed to a reciprocating movement device (15) movable across the installation range of the plurality of the static parts (2), and
the electro-magnetic wave detecting apparatus (12) detects an electro-magnetic wave emitted from a spark while reciprocatingly moving in the installation range of the plurality of the static parts (2).

9. The spark detecting apparatus or method according to any of claims 1 to 3, wherein
a plurality of the static parts (2) are installed,
switches (16) are disposed between the plurality of the static parts (2) and the frequency filter (6), the switches (16) switching the electric connections of the respective static parts (2) and the frequency filter (6), and
the electric connections of the respective static parts (2) and the frequency filter (6) are sequentially switched.

10. The spark detecting apparatus according to any preceding claim comprising, preferably in the detecting apparatus for sliding condition (8), a notification function for notifying spark detection to the outside when it is determined that a spark has occurred.

11. A spark reduction method for devices using electric sliding contact using the spark detecting method for devices using electric sliding contact according to any one of claims 2 to 10,
**characterized in that**
when it is determined that a spark has occurred, the pressing force of the static part (2) against the sliding part (1) is adjusted to reduce spark occurrence.

12. The spark reduction method according to claim 11, wherein
the static part (2) is pressed against the sliding part (1) with a spring (9), and when it is determined that a spark has occurred, the spring (9) is replaced with a high rigidity spring (9) to reduce sparks.

13. The spark reduction method according to claim 11, wherein when it is determined that a spark has occurred, an auxiliary spring (10) is added to increase the pressing force of the static part (2) against the sliding part (1) for reducing sparks.

14. A sliding error detecting apparatus for devices using electric sliding contact including the spark detecting apparatus for devices using electric sliding contact according to any one of claims 1 or 3 to 10,
**characterized in that**
the detecting apparatus for sliding condition (8) has a function of determining the sliding condition of the electric sliding contact based on the presence or absence of spark and the number of sparks within predetermined time.

15. A sliding error detecting method for devices using electric sliding contact using the spark detecting method for devices using electric sliding contact according to any one of claims 2 to 10,
**characterized in that**
the sliding condition of the electric sliding contact is determined based on the presence or absence of spark and the number of sparks within predetermined time.
